# EUROPEAN PATENT APPLICATION

(11) **EP 1 950 884 A1**
(43) Date of publication of application: **30.07.2008**
(21) Application number: 06797226.5
(22) Date of filing: 31.08.2006
(51) Int. Cl.: H03H 11/04

(54) **FILTER ADJUSTING METHOD, FILTER ADJUSTING DEVICE, AND FILTER CIRCUIT**

(30) Priority: 17.11.2005 JP 2005333084
(71) Applicant: Mitsumi Electric Co., Ltd., Tama-shi, Tokyo 206-8567 (JP)
(72) Inventor: SAITOH, Atsushi, Tama-Shi, Tokyo 206-8567 (JP)
(74) Representative: Vinsome, Rex Martin
(86) International application number: PCT/JP2006/317266
(87) International publication number: WO 2007/058012

(57) **Abstract**

The object is to provide a filter circuit as well as a filter adjustment method and a filter adjustment apparatus that can adjust the characteristics of an analog filter by use of a simple configuration.

A filter adjustment method of adjusting the characteristics of an analog filter (111) includes supplying a pseudo-random code to the analog filter (111), computing a cross-correlation between an output of the analog filter (111) and the pseudo-random code, and adjusting the characteristics of the analog filter based on the computed cross-correlation.

## Description

### Technical Field

The present invention generally relates to filter circuits as well as filter adjustment methods and filter adjustment apparatuses for adjusting the characteristics of analog filters, and particularly relates to filter circuits as well as filter adjustment methods and filter adjustment apparatuses for adjusting the characteristics of analog filters.

### Background Art

In electronic apparatuses such as communication equipment, analog filters are often used to allow the passage of signals only in a preferred frequency band. In recent years, there has been a need to implement an analog filter on a semiconductor chip in response to the demand for size reduction of apparatuses.

Conventional analog filters require adjustment in order to control frequency characteristics attributable to variation in the parameters of device components. It is customary to adjust the frequency characteristics of an analog filter by use of an outside part or the like. When an outside capacitance is used to adjust an analog filter, for example, the chip tends to become large because of the need to provide terminals for coupling to the adjustment-purpose capacitance. In consideration of this, there is a need to implement an automatic adjustment circuit for automatically adjusting the frequency characteristics of an analog filter on the same semiconductor chip that carries the analog filter.

Conventional automatic adjustment is performed by supplying a reference signal to a filter, comparing phases between the output of the filter and the reference signal, and controlling the transfer function of the filter based on the phase comparison (see Patent Document 1, for example).

[Patent Document 1] Japanese Patent Application Publication No. 3-114391

### Disclosure of Invention

### Problem to be Solved by the Invention

In the conventional filter adjustment methods, the problem is that a phase comparator, a loop filter, a DC amplifier, and so on are all analog circuits, so that variations in these adjustment-purpose circuits affect the frequency characteristics of the filter. The adjustment process may be digitized in order to improve adjustment accuracy. For such digitization, however, an AD converter and a DA converter are required, and, the number of bits needs to be large for the purpose of providing high accuracy. This results in the size of the circuits being large. Such digitization cannot be employed because the provision of the adjustment circuits on the same chip that carries the filter results in a large chip size.

It is an object of the present invention to provide a filter circuit as well as a filter adjustment method and a filter adjustment apparatus that can perform automatic adjustment by use of a simple configuration.

### Means to Solve the Problem

According to a characteristic aspect of the invention, a filter adjustment method of adjusting characteristics of an analog filter includes: supplying a pseudo-random code to the analog filter; computing a cross-correlation between an output of the analog filter and the pseudo-random code; and adjusting characteristics of the analog filter based on the cross-correlation.

The cross-correlation may be an exclusive-OR value between the output of the analog filter and the pseudo-random code.

According to another characteristic aspect of the invention, a filter adjustment apparatus for adjusting characteristics of an analog filter includes: a pseudo-random-code generating unit to supply a pseudo-random code to the analog filter; a cross-correlation computing circuit to compute a cross-correlation between an output of the analog filter and the pseudo-random code generated by the pseudo-random-code generating unit; and an adjustment unit to adjust characteristics of the analog filter based on the cross-correlation.

The cross-correlation computing circuit may include a logic circuit to perform a logical operation between the output of the analog filter and the pseudo-random code generated by the pseudo-random-code generating unit, and may include a counter to count an output of the logic circuit, wherein the adjustment unit may adjust the characteristics of the analog filter based on the count obtained by the counter.

The logic circuit may perform an exclusive-OR operation between the output of the analog filter and the pseudo-random code.

According to another characteristic aspect of the invention, a filter circuit includes: an analog filter to receive an input signal supplied to an input terminal and to output from an output terminal an output signal obtained by removing or passing desired frequency components in the input signal; a pseudo-random-code generating unit to supply a pseudo-random code to the input terminal of the analog filter; a cross-correlation computing circuit to compute a cross-correlation between an output signal output from the output terminal of the analog filter and the pseudo-random code; and an adjustment unit to adjust characteristics of the analog filter based on the cross-correlation.

The cross-correlation computing circuit may include a logic circuit to perform a logical operation between the output of the analog filter and the pseudo-random code generated by the pseudo-random-code generating unit, and may include a counter to produce a count obtained by counting an output of the logic circuit, wherein the adjustment unit may adjust the characteristics of the analog filter based on the count obtained by the counter.

The logic circuit may perform an exclusive-OR operation between the output of the analog filter and the pseudo-random code.

### Advantage of the Invention

According to an embodiment of the present invention, a cross-correlation between the output of the analog filter and the pseudo-random pattern is computed, and the characteristics of the analog filter are adjusted based on the computed cross-correlation. This makes it possible to evaluate and adjust the characteristics of the analog filter without digitizing the output of the analog filter. Accordingly, the adjustment circuit and the analog filter can be implemented on the same semiconductor chip.

### Brief Description of Drawings

Fig. 1 is a drawing showing the system configuration of a filter circuit according to an embodiment of the present invention.
Fig. 2 is a block diagram of the analog filter 111 shown in Fig. 1.
Fig. 3 is a drawing showing the circuit configuration of the variable capacitance circuit C11 shown in Fig. 2.
Fig. 4 is a flowchart showing the procedure of an adjustment operation performed by the control unit 138 shown in Fig. 1.
Fig. 5 is a drawing showing the operating waveforms of a filter circuit according to an embodiment of the present invention.
Fig. 6 is a drawing showing an example of the relationship between the cutoff frequency of the analog filter 111 and the count of the counter 134.

### Description of Reference Numbers

- 100: filter circuit
- 111: analog filter
- 112: filter adjustment apparatus
- 131: pseudo-random-code generating unit
- 132: inverter
- 133: logic circuit
- 134: counter
- 135: adjustment unit
- 136, 137: switch
- 138: control unit
- 141: subtraction unit
- 142: reference-value supplying unit
- 143: parameter conversion table
- 144: parameter register

### Best Mode for Carrying Out the Invention

### [System Configuration]

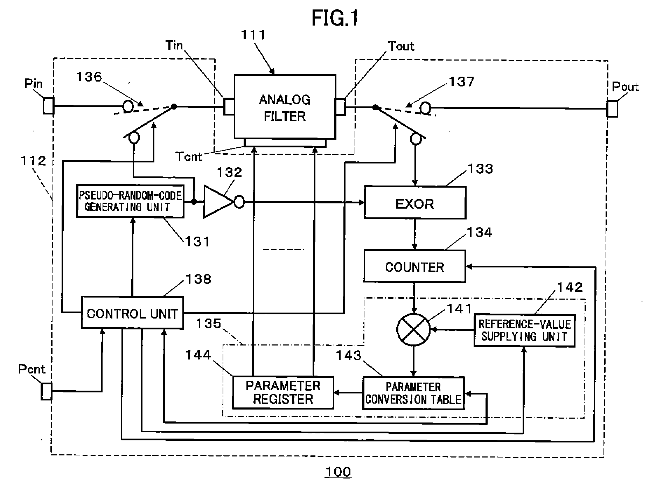

Fig. 1 is a drawing showing the system configuration of a filter circuit according to an embodiment of the present invention.

A filter circuit 100 of this embodiment includes an analog filter 111 and a filter adjustment apparatus 112.

The analog filter 111 receives an input signal supplied to an input terminal Tin, and removes or passes only desired frequency components in the input signal for output from an output terminal Tout.

The filter adjustment apparatus 112 serves to automatically adjust the characteristics of the analog filter 111. The filter adjustment apparatus 112 computes cross-correlation between the output of the analog filter 111 and a pseudo-random pattern to adjust the characteristics of the analog filter based on the computed cross-correlation. The filter adjustment apparatus 112 includes a pseudo-random-code generating unit 131, an inverter 132, a logic circuit 133, a counter 134, an adjustment unit 135, switches 136 and 137, and a control unit 138.

The pseudo-random-code generating unit 131 supplies a pseudo-random code to the input terminal Tin of the analog filter 111. The pseudo-random code generated by the pseudo-random-code generating unit 131 may be a Barker sequence code, an M sequence code, a Gold sequence code, a Kasami sequence code, or the like. The pseudo-random code generated by the pseudo-random-code generating unit 131 is not limited to these sequence codes, but may be any code as long as it contains various frequency components.

The pseudo-random code generated by the pseudo-random-code generating unit 131 is supplied to the inverter 132 as well as to the input terminal Tin of the analog filter 111 via the switch 136. The inverter 132 inverts the logic of the pseudo-random code generated by the pseudo-random-code generating unit 131 for provision to the logic circuit 133.

The logic circuit 133 is comprised of an exclusive-OR (EXOR) gate, and produces an exclusive-OR value between the output signal produced at the output terminal Tout of the analog filter 111 and the pseudo-random code generated by the pseudo-random-code generating unit 131.

The counter 134 counts the logic output "1" from the logic circuit 133. The adjustment unit 135 adjusts the characteristics of the analog filter 111 based on the count obtained by the counter 134.

The switch 136 is situated between the pseudo-random-code generating unit 131, an input port Pin, and the input terminal Tin of the analog filter 111. The switch 136 disconnects the input port Pin as shown by the solid line at the time of adjustment under the control of the control unit 138 to supply the pseudo-random code generated by the pseudo-random-code generating unit 131 to the input terminal Tin of the analog filter 111. The switch 136 closes the connection between the input terminal Tin of the analog filter 111 and the pseudo-random-code generating unit 131 as shown by the dotted line at the time of normal operation to connect between the input terminal Tin of the analog filter 111 and the input port Pin.

The switch 137 is situated between the logic circuit 133, an output port Pout, and the output terminal Tout of the analog filter 111. The switch 137 disconnects the output terminal Tout of the analog filter 111 from the output port Pout at the time of adjustment under the control of the control unit 138 to connect the output terminal Tout to the logic circuit 133. The switch 137 is controlled to connect the output terminal Tout of the analog filter 111 to the output port Pout at the time of normal operation.

The control unit 138 controls the operations of the switches 136 and 137 and the adjustment unit 135 in response to an adjustment control signal supplied to a control port Pcnt.

### [ADJUSTMENT UNIT 135]

The adjustment unit 135 includes a subtraction unit 141, a reference-value supplying unit 142, a parameter conversion table 143, and a parameter register 144.

The subtraction unit 141 subtracts a reference value supplied from the reference-value supplying unit 142 from the count value supplied from the counter 134. The outcome of the subtraction obtained by the subtraction unit 141 represents an error from the reference value. The output of the subtraction unit 141 is supplied to the parameter conversion table 143 and the control unit 138.

The parameter conversion table 143 has parameter values stored in advance that are associated with error values deviating from the reference value. Parameter values may be each comprised of a 6-bit bit sequence. The parameter conversion table 143 supplies the parameter value corresponding to the output of the subtraction unit 141 to the parameter register 144.

The parameter register 144 stores therein the parameter value supplied from the parameter conversion table 143. The parameter value stored in the parameter register 144 is supplied in parallel to control input terminals Tcnt of the analog filter 111.

### [ANALOG FILTER 111]

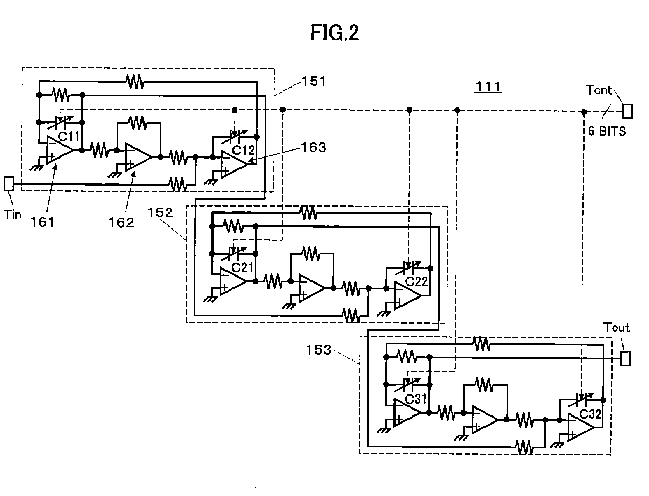

Fig. 2 is a block diagram of the analog filter 111.

The analog filter 111 includes first through third active filter circuit units 151 through 153 connected in series, and constitutes a low-pass filter. The first active filter circuit unit 151 includes variable capacitance circuits C11 and C12. The second active filter circuit unit 152 includes variable capacitance circuits C21 and C22. The third active filter circuit unit 153 includes variable capacitance circuits C31 and C32.

The analog filter 111 is configured such that its frequency characteristics are adjustable by controlling the capacitances of the variable capacitance circuits C11, C12, C21, C22, C31, and C32 in response to control signals supplied to the control input terminals Tcnt.

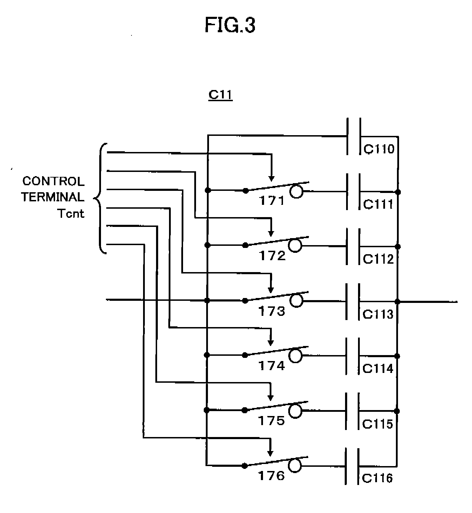

Fig. 3 is a drawing showing the circuit configuration of the variable capacitance circuit C11.

The variable capacitance circuit C11 includes 7 capacitors C110 through C116 and 6 switches 171 through 176, for example.

The capacitor C111 has a capacitance of 32 pF, for example, and is connected to the switch 171 in series. The capacitor C112 has a capacitance of 16 pF, for example, and is connected to the switch 172 in series. The capacitor C113 has a capacitance of 8 pF, for example, and is connected to the switch 173 in series. The capacitor C114 has a capacitance of 4 pF, for example, and is connected to the switch 174 in series. The capacitor C115 has a capacitance of 2 pF, for example, and is connected to the switch 175 in series. The capacitor C116 has a capacitance of 1 pF, for example, and is connected to the switch 176 in series.

The capacitor C110 has a capacitance of 36 pF, for example, and is connected in parallel to the series-connected capacitor C111 and switch 171, the series-connected capacitor C112 and switch 172, the series-connected capacitor C113 and switch 173, the series-connected capacitor C114 and switch 174, the series-connected capacitor C115 and switch 175, and the series-connected capacitor C116 and switch 176.

The switch 171 receives the value of the first bit among the 6 bits of the parameter value supplied to the control terminal Tcnt. The switch 171 becomes ON when the value of the first bit is "1" , and becomes OFF when the value of the first bit is "0".

The switch 172 receives the value of the second bit among the 6 bits of the parameter value supplied to the control terminal Tcnt. The switch 172 becomes ON when the value of the second bit is "1" , and becomes OFF when the value of the second bit is "0" .

The switch 173 receives the value of the third bit among the 6 bits of the parameter value supplied to the control terminal Tcnt. The switch 173 becomes ON when the value of the third bit is "1" , and becomes OFF when the value of the third bit is "0" .

The switch 174 receives the value of the fourth bit among the 6 bits of the parameter value supplied to the control terminal Tcnt. The switch 174 becomes ON when the value of the fourth bit is "1" , and becomes OFF when the value of the fourth bit is "0" .

The switch 175 receives the value of the fifth bit among the 6 bits of the parameter value supplied to the control terminal Tcnt. The switch 175 becomes ON when the value of the fifth bit is "1" , and becomes OFF when the value of the fifth bit is "0".

The switch 176 receives the value of the sixth bit among the 6 bits of the parameter value supplied to the control terminal Tcnt. The switch 176 becomes ON when the value of the sixth bit is "1" , and becomes OFF when the value of the sixth bit is "0".

When the parameter value is "110011" , for example, the switches 171, 172, 175, and 176 are ON, and the switches 173 and 174 are OFF. As a result, the capacitance of the variable capacitance circuit C11 is set equal to 87 pF, which is the capacitance obtained by connecting the capacitors C110, C111, C112, C115, and C116 in parallel. When the parameter value is "101010", for example, the switches 171, 173, and 175 are ON, and the switches 172, 174, and 176 are OFF, resulting in the capacitance of the variable capacitance circuit C11 being 42 pF.

In this manner, the use of the parameter value stored in the parameter register 144 can change the capacitance of the capacitor C11. The variable capacitance circuits C12, C21, C22, C31, and C32 each have a similar configuration to the variable capacitance circuit C11, so that their capacitances can be changed in response to the parameter value stored in the parameter register 144.

### [ADJUSTMENT OPERATION]

In the following, an adjustment operation will be described.

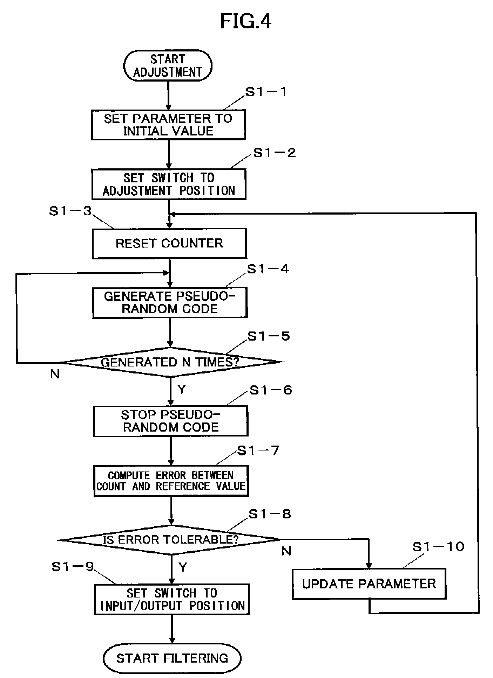

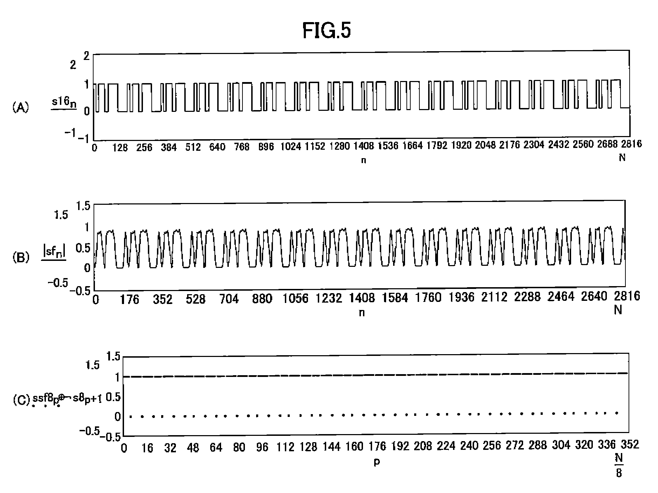

Fig. 4 is a flowchart showing an adjustment operation performed by the control unit 138. Fig. 5 is a drawing showing operating waveforms according to an embodiment of the present invention. Fig. 5-(A) shows a Barker sequence code. Fig. 5-(B) shows a waveform of the output of the analog filter 111 in response to the Barker sequence code. Fig. 5-(C) shows a waveform of the output of the logic circuit 133.

The control unit 138 controls the parameter conversion table 143 in step S1-1 to set an initial value to the parameter register 144 from the parameter conversion table 143. The initial value may be set approximately to a middle value in the range of the variable capacitance of the variable capacitance circuits. To be specific, the range of the variable capacitance of the variable capacitance circuit C11 is from 36 pF to 100 pF, and the middle value in this variable capacitance range is 67 pF. The parameter value may thus be set to "101111". This parameter value "101111" is set as an initial value for the variable capacitance circuit C11. The variable capacitance circuits C12, C21, C22, C31, and C32 each have their initial value set similarly to the manner in which the initial value is set for the variable capacitance circuit C11.

The control unit 138 switches the switch 136 in step S1-2 to supply the output of the pseudo-random-code generating unit 131 to the input terminal Tin of the analog filter 111, and, also, switches the switch 137 to connect the output terminal Tout of the analog filter 111 to the logic circuit 133. The control unit 138 resets the output of the counter 134 to "0" in step S1-3.

The control unit 138 activates the pseudo-random-code generating unit 131 in step S1-4. The pseudo-random-code generating unit 131 generates a pseudo-random code specified by the control unit 138. The pseudo-random code generated by the pseudo-random-code generating unit 131 is supplied to the input terminal Tin of the analog filter 111 via the switch 136, and is also supplied to the logic circuit 133 after logic inversion by the inverter 132. The input terminal Tin of the analog filter 111 receives a Barker sequence code as shown in Fig. 5-(A).

The Barker sequence code passing through the analog filter 111 is output as a waveform as shown in Fig. 5-(B) due to the frequency characteristics set in the analog filter 111.

The waveform as shown in Fig. 5-(B) output from the analog filter 111 is supplied to the logic circuit 133. The logic circuit 133 produces an exclusive-OR value between the signal obtained by inverting the Barker sequence code and the output signal of the analog filter 111. The output of the logic circuit 133 assumes "1" and "0" alternating at predetermined sampling frequencies as shown in Fig. 5-(C). The counter 134 counts the output logic value "1" of the logic circuit 133 shown in Fig. 5-(C).

The control unit 138 checks in step S1-5 whether pseudo-random codes are generated N times, which is a number specified in advance. Upon finding in step S1-5 that pseudo-random codes have been generated N times, the control unit 138 controls the pseudo-random-code generating unit 131 in step S1-6 to stop the generation of pseudo-random codes.

The control unit 138 controls the counter 134 and the reference-value supplying unit 142 in step S1-7 to compute an error that is a difference between the count of the counter 134 and the reference value of the reference-value supplying unit 142. Upon finding in step S1-8 that the error is within a tolerable range, the control unit 138 determines that the adjustment of the analog filter 111 is not necessary. In this case, the control unit 138 switches the switch 136 to couple the input port Pin to the input terminal Tin of the analog filter 111, and also switches the switch 137 to couple the output terminal Tout of the analog filter 111 to the output port Pout.

Further, upon finding in step S1-8 that the error is outside the tolerable range, the control unit 138 supplies the error value to the parameter conversion table 143 in step S1-10 to set a 6-bit parameter value corresponding to the error value to the parameter register 144, thereby adjusting the frequency characteristics of the analog filter 111. After this adjustment, the procedure returns to step S1-3. Subsequently, a check as to the need of the adjustment of frequency characteristics of the analog filter 111 is performed again.

The setting of a parameter value in the parameter register 144 as described above causes the variable capacitance circuits C11, C12, C21, C22, C31, and C32 of the analog filter 111 to assume capacitance values corresponding to the parameter value set in the parameter register 144. This makes it possible to adjust the frequency characteristics of the analog filter 111.

The control unit 138 repeats steps S1-3 through S1-8 until the error falls within the tolerable range.

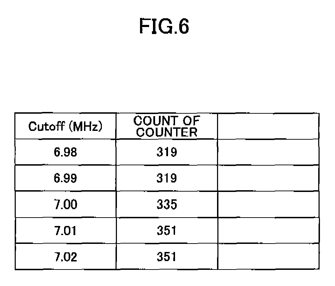

Fig. 6 is a drawing showing an example of the relationship between the cutoff frequency of the analog filter 111 and the count of the counter 134.

As shown in Fig. 6, for example, the count of the counter 134 may be " 319 " for cutoff frequencies of 6.98 MHz and 6.99 MHz, "351" for cutoff frequencies of 7.01 MHz and 7.02 MHz, and "335" for a cutoff frequency of 7.00 MHz.

In this case, if the cutoff frequency of the analog filter 111 is to be set to 7.00 MHz, the reference value supplied from the reference-value supplying unit 142 to the subtraction unit 141 is set to "335" . If the frequency characteristics at present are such that the cutoff frequency is 6.98 MHz or 6.99 MHz, the count becomes 319. The error output from the subtraction unit 141 is -14 (=319-335) in this case. If the frequency characteristics at any given time are such that the cutoff frequency is 7.01 MHz or 7.02 MHz, the count becomes 351. The error output from the subtraction unit 141 is 16 (=351-335) in this case.

A negative error causes such a parameter value to be selected that the capacitances of the variable capacitance circuits C11, C12, C21, C22, C31, and C32 are changed to increase the cutoff frequency of the analog filter 111. A positive error causes such a parameter value to be selected that the capacitances of the variable capacitance circuits C11, C12, C21, C22, C31, and C32 are changed to decrease the cutoff frequency of the analog filter 111.

### [ADVANTAGE]

According to the embodiment, the frequency characteristics of the analog filter 111 can be evaluated without digitizing the output of the analog filter 111, and the parameter of the analog filter 111 can be adjusted based on this evaluation. This makes it possible to provide the filter adjustment apparatus 112 having a relatively simple configuration, so that the filter adjustment apparatus 112 can be implemented on the same semiconductor chip that carries the analog filter 111.

Further, with this configuration in which the analog filter 111 and the filter adjustment apparatus 112 are implemented on the same semiconductor chip, the adjustment of the analog filter 111 can be automatically performed at constant time intervals upon power-on. This makes it possible to attain desired frequency characteristics through automatic adjustment even when parameters are changed with temporal deterioration in the circuit.

### [Other]

In the present embodiment, an output obtained by performing logical operation between the output of the analog filter and a pseudo-random code is counted by the counter, the count of which is then used to perform filter adjustment. Needless to say, however, various modifications may be made as it suffices to compute a cross-correlation between the analog filter and a pseudo-random code. For example, a CCD (charge coupled device) or the like may be employed to compute a cross-correlation between the output of an analog filter and a pseudo-random code.

In the present embodiment, further, a description has been given with reference to an example in which an active low-pass filter serves as the analog filter 111. Notwithstanding this, the analog filter 111 is not limited to a low-pass filter. The present invention is applicable to filters having other frequency characteristics such as a high-pass filter, a band-pass filter, a band-eliminate filter, etc.

In the present embodiment, moreover, an error is converted by use of the parameter conversion table 143. Alternatively, a parameter value may be obtained through computation from an error.

### Industrial Applicability

The present invention is applicable to filter circuits as well as filter adjustment methods and filter adjustment apparatuses for adjusting the characteristics of analog filters.

This international application claims foreign priority to Japanese Patent Application No. 2005-333084 filed on November 17, 2005, the entire contents of which are incorporated herein by reference.

## Claims

1. A filter adjustment method of adjusting characteristics of an analog filter, comprising:
supplying a pseudo-random code to the analog filter;
computing a cross-correlation between an output of the analog filter and the pseudo-random code; and
adjusting characteristics of the analog filter based on the cross-correlation.

2. The filter adjustment method as claimed in claim 1, wherein the cross-correlation is an exclusive-OR value between the output of the analog filter and the pseudo-random code.

3. A filter adjustment apparatus for adjusting characteristics of an analog filter, comprising:
a pseudo-random-code generating unit to supply a pseudo-random code to the analog filter;
a cross-correlation computing circuit to compute a cross-correlation between an output of the analog filter and the pseudo-random code generated by the pseudo-random-code generating unit; and
an adjustment unit to adjust characteristics of the analog filter based on the cross-correlation.

4. The filter adjustment apparatus as claimed in claim 3, wherein the cross-correlation computing circuit includes:
a logic circuit to perform a logical operation between the output of the analog filter and the pseudo-random code generated by the pseudo-random-code generating unit; and
a counter to count an output of the logic circuit,
wherein the adjustment unit adjusts the characteristics of the analog filter based on the count obtained by the counter.

5. The filter adjustment apparatus as claimed in claim 4, wherein the logic circuit performs an exclusive-OR operation between the output of the analog filter and the pseudo-random code.

6. A filter circuit, comprising:
an analog filter to receive an input signal supplied to an input terminal and to output from an output terminal an output signal obtained by removing or passing desired frequency components in the input signal;
a pseudo-random-code generating unit to supply a pseudo-random code to the input terminal of the analog filter;
a cross-correlation computing circuit to compute a cross-correlation between an output signal output from the output terminal of the analog filter and the pseudo-random code; and
an adjustment unit to adjust characteristics of the analog filter based on the cross-correlation.

7. The filter circuit as claimed in claim 6, wherein the cross-correlation computing circuit includes:
a logic circuit to perform a logical operation between the output of the analog filter and the pseudo-random code generated by the pseudo-random-code generating unit; and
a counter to produce a count obtained by counting an output of the logic circuit,
wherein the adjustment unit adjusts the characteristics of the analog filter based on the count obtained by the counter.

8. The filter circuit as claimed in claim 7, wherein the logic circuit performs an exclusive-OR operation between the output of the analog filter and the pseudo-random code.
